**Europäisches Patentamt**

**European Patent Office**

**Office européen des brevets**

(11) Numéro de publication: **0 103 502**
**A1**

## (12) DEMANDE DE BREVET EUROPEEN

(21) Numéro de dépôt: 83401633.9

(22) Date de dépôt: 09.08.83

(51) Int. Cl.³: **H 01 J 37/147,** H 01 J 37/317, H 01 J 3/26

(30) Priorité: 17.08.82 FR 8214204

(43) Date de publication de la demande: 21.03.84
Bulletin 84/12

(84) Etats contractants désignés: DE GB NL

(71) Demandeur: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Bruel, Michel, Presvert 9, F-38113 Veurey (FR)**
Inventeur: **Michaud, Jean-Francois, Saint Pierre de Soucy, F-73800 Montmelian (FR)**

(74) Mandataire: **Mongrédien, André et al, c/o BREVATOME 25, rue de Ponthieu, F-75008 Paris (FR)**

(54) Procédé pour faire varier en fonction du temps la trajectoire d'un faisceau de particules chargées.

(57) Procédé pour faire varier la déflexion de la trajectoire (4) d'un faisceau de particules chargées sur un chemin de longueur 1 dans un volume d'espace V où existe une induction magnétique B (x, y, z).

On crée un déplacement relatif de ce volume V par rapport au faisceau de façon à faire varier la grandeur $\int Bdl$ calculée le long du chemin et caractéristique de la déflexion subie par le faisceau lors de sa traversée de ce volume V.

**EP 0 103 502 A1**

1

La présente invention a trait aux techniques utilisées pour obtenir la déflexion de la trajectoire des faisceaux de particules chargées, tels que par exemple, les faisceaux d'ions intenses utilisés dans les implanteurs ioniques.

On sait que les faisceaux d'ions lourds de même signe, atteignant ou dépassant une certaine densité, par exemple de l'ordre du mA/cm$^2$, sont difficiles à maintenir en l'état, étant donné les forces de répulsion très importantes qui s'exercent entre les diverses particules et qui, sans précautions spéciales, auraient tendance à provoquer l'éclatement du faisceau. De tels faisceaux ne peuvent exister que s'ils comportent un minimum de charges spatiales de particules du signe opposé à celles du faisceau, notamment des électrons lorsqu'il s'agit d'un faisceau d'ions lourds positifs. Ces électrons sont en général présents au sein du faisceau du fait même qu'un vide total ne peut jamais être fait dans l'enceinte où se déplace le faisceau et qu'une partie de l'air résiduel ionisé fournit précisément ces électrons nécessaires.

Pour pouvoir manipuler de tels faisceaux d'ions lourds, de haute densité, il est donc important de ne pas détruire la compensation par cette charge spatiale de particules de signe opposé, ce qui exclut par conséquent tout recours à des champs électriques pour obtenir les déviations du faisceau nécessaires à son utilisation. C'est pourquoi, on a recours couramment, pour faire varier la déflexion de la trajectoire du faisceau, à des champs magnétiques qui permettent la conservation de la compensation précédente tout en assurant une déviation adéquate.

Dans l'art antérieur connu, on obtient donc la déflexion du faisceau en faisant varier le rayon de courbure de la trajectoire qu'il suit par création d'une zone où le champ magnétique est variable en fonction du temps. Ceci est réalisé généralement grâce à un circuit magnétique comportant un entrefer et dans lequel circule le flux induit par une bobine de magnétisation dans laquelle on injecte le courant d'intensité variable qui crée le champ magnétique variable.

Tous ces procédés de déflexion connus conduisent à des inconvénients sérieux qui sont d'une part des pertes par courants de Foucault et hystérésis dans le matériau magnétique soumis au champ variable, qui sont loin d'être négligeables, et la mise en jeu d'une puissance réactive relativement importante lors de la variation du champ magnétique. A titre d'exemple de ce dernier inconvénient, on peut citer le cas du balayage d'un faisceau d'ions d'antimoine de 200 keV avec un angle de plus ou moins 1°, à 50 Hz. Si le volume d'espace magnétisé correspond à un entrefer dont les dimensions sont : longueur environ 0,2 mètre, largeur 0,2 mètre, épaisseur de l'entrefer 0,1 mètre, l'obtention dans cet entrefer d'un champ maximum de 1000 Gauss ou 0,1 Tesla conduit à la mise en jeu d'une puissance réactive de l'ordre de 5,8 KVA. Une puissance réactive de cet ordre de grandeur est très néfaste à l'équilibre du réseau électrique auquel elle est empruntée.

La présente invention a précisément pour objet un procédé qui permet de faire varier la déflexion de la trajectoire d'un faisceau de particules chargées en utilisant le champ magnétique pour cette déflexion, mais qui permet, par la mise en oeuvre de moyens simples et efficaces, d'éviter les inconvénients préalablement rappelés dans l'art antérieur en matière de perte par hystérésis, courants de Foucault et déséquilibre du réseau par puissance réactive importante consommée.

portante consommée.

Ce procédé pour faire varier la déflexion de la trajectoire d'un faisceau de particules chargées sur un chemin de longueur l dans un volume d'espace V où existe une induction magnétique $\vec{B}$ (x, y,z), se caractérise en ce que l'on crée un déplacement relatif de ce volume V par rapport au faisceau de façon à faire varier la grandeur $\int Bdl$ calculée le long du chemin et caractéristique de la déflexion subie par le faisceau lors de sa traversée de ce volume V.

L'angle de déflexion α d'un faisceau de particules chargées traversant une zone d'induction magnétique de volume V de longueur l et d'intensité B perpendiculaire à la trajectoire est fonction, pour un type d'ions et une énergie donnée, de la valeur de l'intégrale $\int Bdl$ calculée le long de ce chemin. Dans l'art antérieur, on obtenait les variations de l'angle α en fonction du temps en faisant varier l'induction B également en fonction du temps. Le procédé, objet de la présente invention, consiste essentiellement à faire varier l'intégrale $\int Bdl$ le long du chemin parcouru par le faisceau de particules chargées pour obtenir la variation de l'angle α. On obtient ainsi, conformément à l'invention, un angle α de déflexion du faisceau qui est fonction de la position du faisceau par rapport au volume V. De façon pratique d'ailleurs, c'est en créant un déplacement relatif du volume V par rapport au faisceau que l'on fait varier la valeur de l'intégrale $\int Bdl$ vue par le faisceau lui-même et que l'on obtient ainsi la déflexion recherchée.

Il faut noter que selon l'invention, l'induction $\vec{B}$ (x,y,z) n'est pas fonction du temps comme elle l'était dans l'art antérieur et que l'on peut l'obtenir grâce à un système magnétisant indépendant

B 7536 3 AM

du temps, tel qu'un aimant permanent ou un circuit magnétique magnétisé par un nombre constant d'ampères.tours. Différentes variantes de mise en oeuvre du procédé peuvent être envisagées sans sortir du cadre de l'invention.

Dans une première variante, l'induction magnétique est uniforme dans un volume V en forme de parallélépipède rectangle par exemple que l'on fait tourner autour d'un axe perpendiculaire à deux de ses faces et à la direction du faisceau.

Dans une deuxième variante, l'induction magnétique étant non uniforme dans le volume V, on fait tourner ce dernier autour d'un axe perpendiculaire au faisceau et parallèle à l'induction.

Dans une troisième variante, le volume V est fixe dans l'espace mais l'induction est non uniforme et l'on fait se déplacer le faisceau par rapport au volume V avant son entrée dans celui-ci.

Dans une quatrième variante encore, le volume V est mobile en rotation autour d'un axe perpendiculaire au faisceau et comprend deux zones adjacentes et sensiblement égales dans lesquelles l'induction, parallèle à l'axe de rotation, est de sens opposé de l'une à l'autre.

De toute façon l'invention sera mieux comprise à la lecture qui suit d'un certain nombre d'exemples de mise en oeuvre qui seront décrits à titre illustratif et non limitatif en se référant aux figures 1 à 4 ci-jointes sur lesquelles :

- les figures 1a (vue de dessus) et 1b (en élévation) représentent un exemple de déflexion variable de la trajectoire d'un faisceau de particules chargées utilisant un volume V en forme de parallélépipède rectangle ;

- la figure 2a représente un mode de mise en oeuvre du procédé objet de l'invention dans lequel on obtient une déflexion variable de la trajectoire d'un faisceau de particules chargées en faisant tourner un volume V dans lequel l'induction magnétique n'est pas uniforme ;

- la figure 2b est une coupe du dispositif de la figure 2a selon AA ;

- les figures 3a et 3b représentent en élévation et vu de dessus un dispositif d'amplification de balayage dans lequel le volume V est fixe dans l'espace, l'induction est non uniforme et le faisceau se déplace avant son entrée dans le système ;

- les figures 4a et 4b montrent en coupe élévation et en plan, un système de mise en oeuvre du procédé de déflexion objet de l'invention comprenant deux zones adjacentes sensiblement égales dans lesquelles l'induction est de sens opposé de l'une à l'autre.

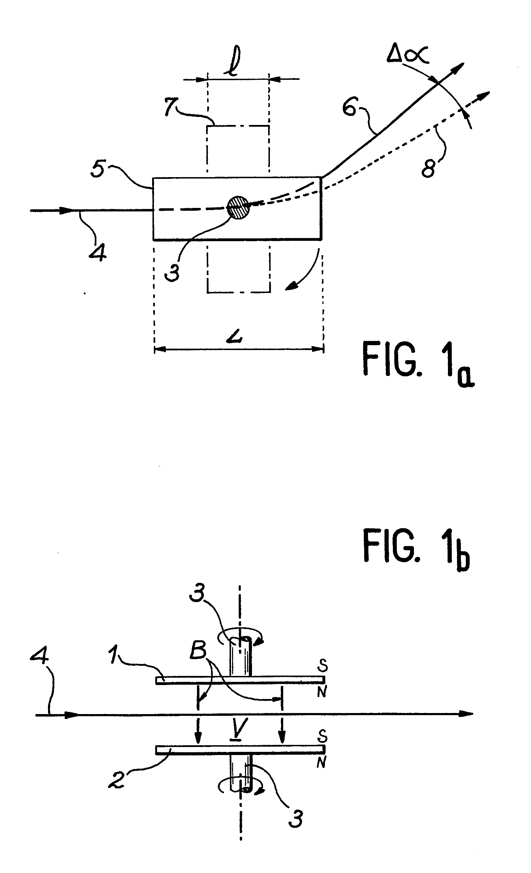

Sur les figures 1a et 1b, on a représenté un volume V magnétisé à l'aide de deux ferrites 1 et 2 possèdant des pôles nord et sud ainsi qu'indiqué sur le dessin. Dans le volume V, il en résulte par conséquent, une induction B uniforme schématisée par les flèches. Selon l'invention, l'ensemble des deux ferrites 1 et 2, est mobile en rotation autour d'un axe 3 perpendiculaire à leur plan commun et passant par leur centre de symétrie, de façon à les rendre solidaires en rotation. L'axe de rotation 3 est perpendiculaire à la direction générale du faisceau 4 entrant dans le système. Lorsque les deux ferrites occupent la position 5 marquée en trait plein sur la figure 1a, la valeur de l'intégrale $\int Bdl$ est maximale et la trajectoire du faisceau à la sortie est repérée par le chiffre 6 ; lorsqu'au contraire les ferrites 1 et 2 ayant tourné de 90° autour de l'axe 3 sont dans la position 7 représentée en pointillés sur la figure 1a, l'inté-

B 7536 3 AM

grale $\int$ Bdl a la valeur minimale puisque la longueur l
traversée est elle-même minimale, et la trajectoire du
faisceau à la sortie est indiquée par la référence 8.
On obtient ainsi par une simple rotation du système
constitué par les deux ferrites 1 et 2, c'est-à-dire
du volume V magnétisé, une déflexion qui peut varier
d'un angle Δα compris entre les déflexions extrêmes 6
et 8.

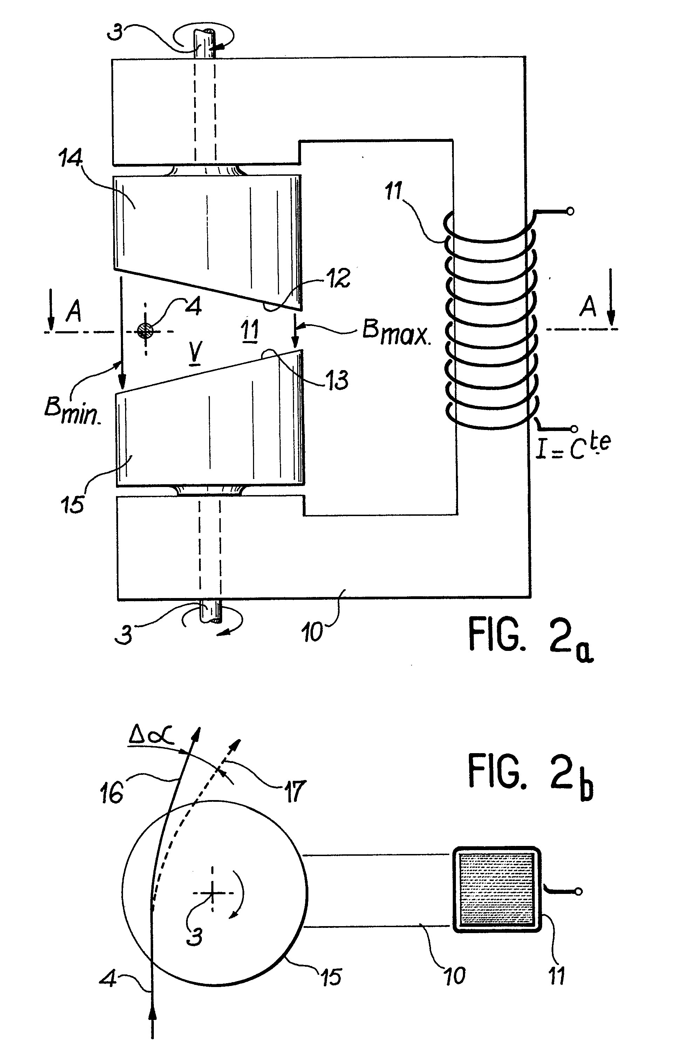

Sur les figures 2a et 2b, on a représenté un
autre exemple de mise en oeuvre du procédé objet de
l'invention dans lequel le volume V magnétisé tourne
autour d'un axe 3 perpendiculaire au faisceau incident
4 et parallèle au vecteur induction B. Le dispositif
représenté en coupe élévation sur la figure 2a et en
vue de dessus selon la coupe AA sur la figure 2b,
comporte essentiellement un circuit magnétique fixe 10
de section préférentiellement circulaire, dans lequel
on fait circuler à l'aide d'une bobine 11 comprenant
un certain nombre n de spires, un courant I constant
correspondant à une force magnéto-électrique de nI ampères.tours. Ce circuit magnétique 10 comporte un entrefer 11 délimité par deux plans inclinés 12 et 13
appartenant à des pièces polaires 14 et 15 agencées de
façon à pouvoir tourner de façon solidaire autour de
l'axe de rotation 3 situé dans le plan de la figure
2a. La configuration de l'entrefer 11 conduit à l'obtention d'une induction magnétique B dirigée selon les
flèches, mais non uniforme dans l'ensemble du volume V
de l'entrefer 11 puisque son intensité, c'est-à-dire
le module du vecteur B, varie de façon inverse de
l'épaisseur locale de l'entrefer. En d'autres termes,
dans la position des pôles 14 et 15 représentée sur la
figure 2a, l'induction B est minimale sur la face externe située à gauche de l'entrefer et maximale sur la
face interne située à droite de celui-ci. Le faisceau

B 7536 3 AM

de particules chargées dont on veut faire varier la déflexion dans le volume V étant situé en 4 de façon excentrée par rapport à l'axe 3, il suffit de faire tourner les pôles 14 et 15 autour de cet axe 3 pour que le module du vecteur B vu par ce faisceau 4 varie dans le temps, et provoquer ainsi une déflexion plus ou moins grande de ce faisceau 4. Sur la figure 2b, on voit la déflexion minimale 16 correspondant à l'induction B minimale et la déflexion maximale 17 correspondant à l'induction B maximale dans le volume V au niveau du faisceau 4. Les deux déflexions minimale 16 et maximale 17 sont distantes angulairement parlant d'un angle $\Delta\alpha$ qui concrétise les limites de la variation de la déflexion de trajectoire que l'on peut imposer au faisceau entrant 4, par le dispositif des figures 2a et 2b.

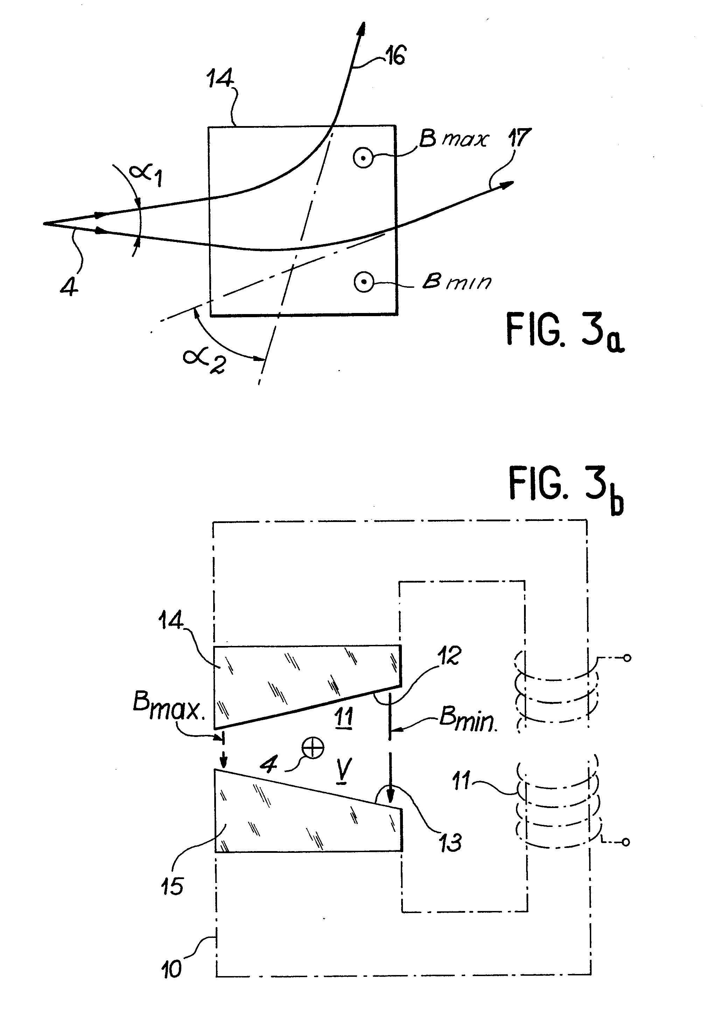

Le dispositif des figures 3a et 3b est destiné à amplifier un balayage de faisceau initial obtenu de façon connue par des moyens mécaniques ou électriques qui ne font pas partie de la présente invention. Ce dispositif a la particularité d'être entièrement statique et il comporte essentiellement comme dans le cas précédent des figures 2a et 2b un circuit magnétique fixe 10 alimenté par une bobine 11 parcourue par un courant d'intensité I et correspondant à une force magnéto-motrice de nI ampères.tours.

Comme dans le cas précédent, ce circuit magnétique 10 est muni d'un entrefer 11 défini par les pôles magnétiques 14 et 15 délimités par les surfaces planes inclinées en regard 12 et 13, définissant dans l'entrefer 11 une induction magnétique B dont la direction est schématisée par les flèches et dont l'intensité, non uniforme, est variable d'une extrémité à l'autre de l'entrefer 11. La différence essentielle avec le dispositif précédent réside dans le fait que,

B 7536 3 AM

dans l'exemple des figures 3a et 3b, les pièces polaires 14 et 15 sont fixes et que c'est le faisceau 4 lui-même que l'on fait se déplacer dans le plan de la figure 3a d'un angle $\alpha 1$ limité à quelques degrés, mais qui se trouve amplifié dans le système puisque l'angle $\alpha 2$ délimité par les déviations extrêmes 16 et 17 du faisceau de particules chargées est beaucoup plus grand que l'angle $\alpha 1$ d'ouverture de balayage initial. Ainsi, lorsque le faisceau 4, avant son entrée dans le système des figures 3a et 3b, oscille d'un angle $\alpha 1$ de quelques degrés, le faisceau sortant balaye l'espace compris entre les faisceaux limites 16 et 17 se déplaçant ainsi d'un angle $\alpha 2$ très supérieur à l'angle $\alpha 1$ de balayage initial ($\alpha 2$ souvent supérieur à $10\alpha 1$).

Ce dispositif peut être utile lorsque l'on veut obtenir, à partir de moyens mécaniques ou électriques connus provoquant un balayage initial faible, une déflexion angulaire beaucoup plus importante et automatique d'un faisceau de particules chargées.

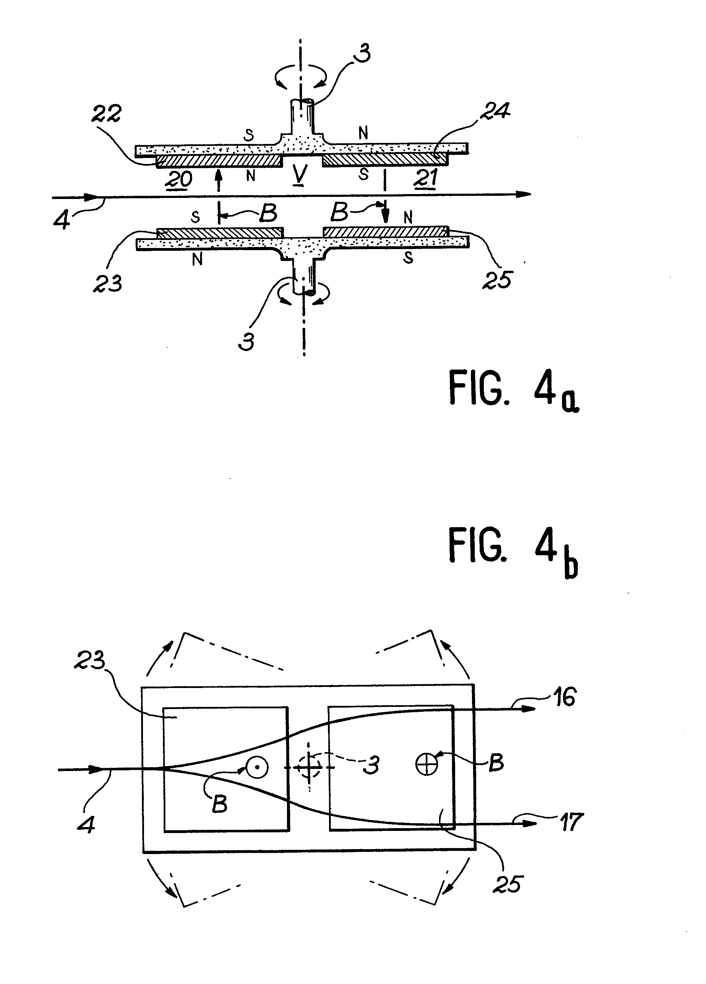

Le dispositif des figures 4a et 4b montre un autre exemple de mise en oeuvre du procédé objet de l'invention et comporte essentiellement comme on le voit sur la figure 4a, dans un volume V mobile en rotation autour d'un axe 3, deux zones contiguës et d'égal volume 20 et 21 dans lesquelles l'induction B est de même direction, de même intensité, mais de sens opposés, dans l'une des zones par rapport à l'autre. Ceci est obtenu facilement par exemple à l'aide de quatre ferrites dont les pôles nord et sud sont répartis comme indiqué sur la figure 4a. Si l'on regarde maintenant en se référant à la vue de dessus représentée sur la figure 4b ce qui se passe lorsqu'un faisceau de particules chargées 4 entre dans le système, on comprend que ce faisceau est dévié dans chacune des zones 20 et 21 en sens opposé, ce qui conduit pour une première position du système des quatre ferrites 22, 23, 24 et 25 à la trajectoire extrême 16 et pour la position de ces mêmes quatre ferrites après un demi-tour de rotation autour de l'axe 3 à la trajectoire extrême 17. On conçoit donc que pour les positions intermédiaires du volume V, la déflexion de la trajectoire du faisceau se situe entre les trajectoires extrêmes précédentes 16 et 17.

Dans tous les exemples décrits précédemment en se référant aux différentes figures, on voit donc que la variation de déflexion de la trajectoire du faisceau de particules chargées est obtenue par des moyens magnétiques faisant varier l'intégrale $\int B dl$ vue par le faisceau dans le volume V sans qu'il y ait aucunement consommation de puissance réactive ni perte par hystérésis ou courant de Foucault puisque les champs magnétiques sont obtenus soit par des aimants permanents soit par des circuits électromagnétiques alimentés par des courants constants.

## REVENDICATIONS

1. Procédé pour faire varier la déflexion de la trajectoire (4) d'un faisceau de particules chargées sur un chemin de longueur l dans un volume d'espace V où existe une induction magnétique B (x,y,z), caractérisé en ce que l'on crée un déplacement relatif de ce volume V par rapport au faisceau de façon à faire varier la grandeur $\int Bdl$ calculée le long du chemin et caractéristique de la déflexion subie par le faisceau lors de sa traversée de ce volume V.

2. Procédé selon la revendication 1, caractérisé en ce que l'induction magnétique est créée par au moins un aimant permanent (1, 2).

3. Procédé selon la revendication 1, caractérisé en ce que l'induction magnétique est créée par un circuit magnétique (10) doté d'un entrefer (11) définissant le volume V et magnétisé par un nombre constant d'ampères-tours.

4. Procédé selon l'une quelconque des revendications 1 à 3, caractérisé en ce que l'induction magnétique est uniforme dans un volume V en forme de parallélépipède rectangle que l'on fait tourner autour d'un axe (3) perpendiculaire à deux de ses faces et à la direction du faisceau (4).

5. Procédé selon l'une quelconque des revendications 1 à 3, caractérisé en ce que l'induction magnétique étant non uniforme dans le volume V, on fait tourner ce dernier autour d'un axe (3) perpendiculaire au faisceau et parallèle à l'induction.

6. Procédé selon l'une quelconque des revendications 1 à 3, caractérisé en ce que le volume V est fixe dans l'espace, l'induction est non uniforme et l'on fait se déplacer le faisceau (4) par rapport au volume V avant son entrée dans celui-ci.

B 7536 3 AM

11

7. Procédé selon l'une quelconque des revendications 1 à 3, caractérisé en ce que le volume V est mobile en rotation autour d'un axe (3) perpendiculaire au faisceau (4) et comprend deux zones adjacentes (20, 21) et sensiblement égales dans lesquelles l'induction, parallèle à l'axe de rotation (3), est de sens opposé de l'une à l'autre.

B 7536 3 AM

FIG. 1$_a$

FIG. 1$_b$

FIG. 2a

FIG. 2b

FIG. 3ₐ

FIG. 3_b

FIG. 4$_a$

FIG. 4$_b$

0103502

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | IBM TECHNICAL DISCLOSURE BULLETIN, vol. 19, no. 9, février 1977, Armonk, N.Y. (US) J.R. WINNARD:"Ion-beam scanning by magnetic means", pages 3411-3412 * En entier * | 1-3 | H 01 J 37/147 H 01 J 37/317 H 01 J 3/26 |
| | --- | | |
| A | EP-A-0 002 990 (ANVAR) * Page 5, ligne 28 - page 9, ligne 9 * | 1 | |
| | --- | | |
| A | NUCLEAR INSTRUMENTS AND METHODS IN PHYSICS RES., vol. 189, no. 1, octobre 1981, Amsterdam (NL) P.R. HANLEY:"Electromagnetic scanning systems", pages 227-237 * Paragraphes 2,3,4 * | 1 | |
| | ----- | | **DOMAINES TECHNIQUES RECHERCHES (Int. Cl. 3)** |
| | | | H 01 J 37 H 01 J 3 |

Le présent rapport de recherche a été établi pour toutes les revendications

| Lieu de la recherche LA HAYE | Date d'achèvement de la recherche 25-11-1983 | Examinateur SCHAUB G.G. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503 03 82